Europäisches Patentamt

European Patent Office

Office européen des brevets

(11) Numéro de publication: **0 013 207**
**B1**

(12) **FASCICULE DE BREVET EUROPEEN**

(45) Date de publication du fascicule de brevet:
05.05.82

(21) Numéro de dépôt: **79400989.4**

(22) Date de dépôt: **07.12.79**

(51) Int. Cl.³: **H 03 K 4/50,** H 04 N 3/16

(54) Circuit oscillateur générateur de dents de scie et récepteur de télévision comportant un tel oscillateur.

(30) Priorité: **29.12.78 FR 7836959**

(43) Date de publication de la demande:
**09.07.80 Bulletin 80/14**

(45) Mention de la délivrance du brevet:
**05.05.82 Bulletin 82/18**

(84) Etats contractants désignés:
**DE GB IT NL**

(56) Documents cités:

**WIRELESS WORLD, vol. 79, n° 1448
février 1973
Londres, GB
D. SMITH: «Versatile Triangle Wave Generator»,
pages 87 - 89.**

(73) Titulaire: **THOMSON-CSF, 173, Boulevard Haussmann,
F-75360 Paris Cedex 08 (FR)**

(72) Inventeur: **Moreau, Jean-Michel, "THOMSON-CSF" -
SCPI 173, bld Haussmann, F-75360 Paris Cedex 08 (FR)**

(74) Mandataire: **Giraud, Pierre et al, THOMSON-CSF
SCPI 173, bld Haussmann, F-75360 Paris Cedex 08 (FR)**

ACTORUM AG.

Circuit oscillateur générateur de dents de scie et récepteur de télévision comportant un tel oscillateur

La présente invention est relative aux oscillateurs dits «en dents de scie» employés couramment pour commander la déviation du faisceau dans les tubes reproducteurs d'image, telle que par exemple la déviation verticale des tubes de télévision. Ils délivrent un signal électrique constitué par une suite de rampes monotones séparées par des retours rapides à la valeur initiale. L'invention concerne plus précisément un oscillateur en dents de scie, dont la conception simplifie la réalisation des récepteurs de télévision, en améliore la fiabilité en diminuant le nombre des connexions électriques et facilite une plus grande densité d'intégration dans le cas où le circuit est réalisé sous forme de circuit intégré monolithique.

Les ondes en dents de scie qui commandent le balayage vertical du faisceau d'électrons sur l'écran d'un tube image doivent obligatoirement satisfaire à des critères:
- de fréquence, qui correspond elle-même à la vitesse de balayage des images sur l'écran;
- d'amplitude, qui correspond aux limites géométriques de l'image sur l'écran.

Ces réglages, obtenus par tous moyens conventionnels, tels que potentiomètres, capacités ou auto-inductances variables ou encore courants ou tensions d'asservissements, nécessitent généralement qu'une connexion électrique au moins amène la valeur de réglage jusqu'au point fonctionnel du circuit oscillateur. Dans les circuits oscillateurs connus, ces réglages se font en un point situé, selon les cas, au «début» ou au «milieu» du schéma électrique équivalent, ce qui nécessite donc au moins une borne de connexion supplémentaire.

Le circuit oscillateur selon l'invention est conçu de façon telle que le réglage peut se faire au moyen d'un potentiomètre connecté sur la borne de sortie: il intervient donc «après» le schéma électrique équivalent, ne nécessitant aucune borne de connexion qui lui soit expressément réservée, et ne nécessitant plus aucune connexion supplémentaire à l'intérieur du circuit.

De façon plus précise, l'invention concerne un circuit oscillateur, générateur de dents de scie, comportant un condensateur, alimenté par un générateur de courant, lequel fonctionne dans deux sens et, soit fournit au condensateur un courant, soit absorbe un courant, et un amplificateur suiveur, lequel délivre sur la borne de sortie le courant en dent de scie, caractérisé en ce qu'un premier comparateur compare la tension Vc aux bornes de la capacité à celle d'un premier seuil de tension prédéterminée et qu'un second comparateur compare le courant de sortie à un second seuil de courant prédéterminé, chaque comparateur restant bloqué dans son état jusqu'à ce que l'autre comparateur ait atteint le seuil qui lui correspond, les comparateurs appliquant des signaux de commande au générateur de courant pour déterminer les intervalles de temps durant lesquels il fournit un courant et durant lesquels il absorbe un courant.

L'invention sera mieux comprise au moyen de la description qui suit, laquelle s'appuie sur les figures qui représentent:
figure 1 une onde électrique en dents de scie et les réglages afférents;
figure 2 le schéma électrique sous forme de blocs fonctionnels d'un circuit oscillateur selon l'art connu;
figure 3 différentes variantes du circuit précédent;
figure 4 le schéma électrique sous forme de blocs fonctionnels du circuit oscillateur selon l'invention;
figure 5 le schéma électrique du circuit selon l'invention.

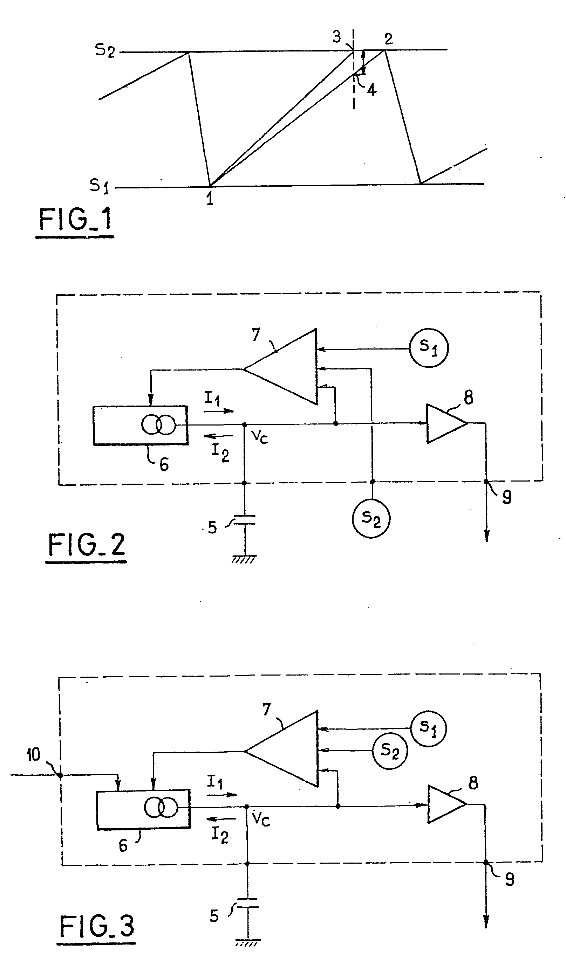

La figure 1 représente une dent de scie, fournie par le circuit oscillateur. Dans le but de simplifier le texte et les figures, la dent de scie est représentée par des segments de droite, alors qu'en fait elle est superposée à:
- une déviation en «S» pour corriger la forme non sphérique de l'écran du tube image;
- une déviation en «C» pour corriger le champ électromagnétique.

L'onde en dents de scie est comprise entre un seuil inférieur $S_1$ et un seuil supérieur $S_2$:

Chaque dent de scie comporte une rampe montante de 1 vers 2, suivie d'une rampe descendante.

Dans le cas du balayage vertical en télévision, la rampe montante a une durée de 25 millisecondes environ lorsque l'oscillateur oscille librement, et la rampe descendante a une durée de 1,6 ms environ: la fréquence de la dent de scie est ramenée à 20 ms par le réglage de fréquence, imposé par une impulsion de synchronisation générée dans le récepteur de télévision.

Le réglage de fréquence, en diminuant la durée de la rampe montante, dont la crête est ramenée en 4, diminue également l'amplitude de la dent de scie: un réglage d'amplitude s'impose qui, en modifiant la pente de la rampe montante, en ramène la crête au point 3.

Deux réglages sont donc nécessaires, en fréquence et en amplitude, obtenus soit par le ou les seuils $S_1$ et $S_2$, soit par le générateur courant qui modifie la pente.

Ce préambule sur les ondes en forme de dents de scie sera utile, au cours des explications qui vont suivre, pour saisir plus facilement les impératifs et les contraintes des générateurs de dents de scie.

La figure 2 représente le schéma électrique, sous forme de diagramme fonctionnel, d'un oscillateur en dents de scies selon l'art connu.

Selon ce schéma, un condensateur 5 de capacité C a une de ses extrémités réunie au potentiel de référence (masse du circuit), tandis que l'autre extrémité est connectée à la borne de sortie d'un générateur de courant 6.

Il est connu que l'on appelle générateur de courant, un dispositif électrique capable de faire passer, dans un circuit qui lui est connecté, un courant pratiquement indépendant, dans certaines limites, de ce dernier circuit.

Ce générateur de courant présente la caractéristique de pouvoir délivrer deux courants différents en sens et en grandeur, selon les signaux de commande qui lui sont appliqués. Quand il reçoit un certain type de signal de commande, il fournit à la capacité un courant entrant de valeur $I_1$; s'il reçoit un autre type de signal de commande, il soutire à la capacité un courant $I_2$ plus élevé. Un circuit comparateur de tension 7, doté d'une mémoire, compare la tension présente sur le condensateur avec deux seuils de tension prédéterminés $S_1$ et $S_2$.

Lorsque le condensateur reçoit le courant $I_1$, la tension à ses bornes Vc croît alors avec une vitesse

$$\frac{dVc}{dt} = \frac{I_1}{C}$$

Quand la tension Vc devient supérieure à la tension $S_2$, le comparateur 7 envoie sur le générateur de courant 6 un signal de commande tel que ce dernier absorbe le courant $I_2$: la tension Vc décroît à la vitesse

$$\frac{dVc}{dt} = -\frac{I_2}{C}$$

jusqu'à ce que la tension Vc devienne inférieure à la tension $S_1$. A partir de ce moment, le comparateur 7 envoie à nouveau sur le générateur de courant 6 une commande telle que le condensateur 5 reçoit à nouveau $I_1$, et le cycle recommence.

La tension Vc aux bornes du condensateur, est donc constituée d'une suite de rampes de tension croissantes en fonction du temps à la vitesse:

$$\frac{dV}{dt} = \frac{I_1}{C}$$

séparées par des retours rapides à la valeur initiale. Cette tension n'est pas, en général, utilisée directement mais recopiée par un amplificateur 8 à forte impédance d'entrée, qui fournit une tension de forme semblable sous une faible impédance de sortie, sur la borne de sortie 9.

Des dispositifs conformes à cette description sont très fréquemment employés comme oscillateurs de balayage vertical pour la télévision. Ils peuvent être modifiés de diverses manières: par exemple certaines modifications permettent de déformer légèrement les rampes linéaires de tension pour compenser les irrégularités de balayage dues à la forme du tube image.

Sur le schéma représenté par la figure 2, le seuil supérieur $S_2$ — ou tout au moins un élément de réglage de $S_2$ — est représenté en dehors de la pastille de matériau semi-conducteur, symbolisé par un cadre en trait discontinu.

En se reportant à ce qui a été dit précédemment, un autre procédé de réglage de la dent de scie consiste à modifier le courant fourni par le générateur 6.

La figure 3 représente un tel oscillateur selon l'art connu. Par comparaison avec la figure 2, il apparaît que les deux générateurs de tensions de seuils $S_1$ et $S_2$ sont intégrés dans le schéma, mais que le signal de réglage est appliqué sur le générateur de courant 6, par la borne de connexion 10.

Une autre variante, non représentée, consiste à régler l'amplitude de la dent de scie au moyen des deux seuils $S_1$ et $S_2$, ce qui a pour conséquence de nécessiter une connexion supplémentaire pour le réglage du deuxième seuil.

Le problème des connexions externes n'est pas sans importance. En premier lieu, une connexion externe nécessite un point de contact électrique entre deux conducteurs, soit par soudure, soit par enroulement (technique dite du «wrapping»), ce qui ne peut que nuire à la fiabilité du matériel. En second lieu, l'oscillateur en dents de scie n'est, très généralement, qu'un élément dans un ensemble plus complexe tel que par exemple un circuit de balayage en télévision ou tout autre générateur de fonction. Par conséquent, il est important de supprimer au maximum les connexions externes auxquelles correspondent des liaisons internes, sous forme de métallisations en surface du cristal semi-conducteur, métallisations qui diminuent la densité d'intégration.

C'est pour éviter ces inconvénients de l'art antérieur qu'un oscillateur nouveau a été étudié, dans lequel les réglages peuvent être effectués au moyen d'une résistance variable connectée à la sortie du circuit.

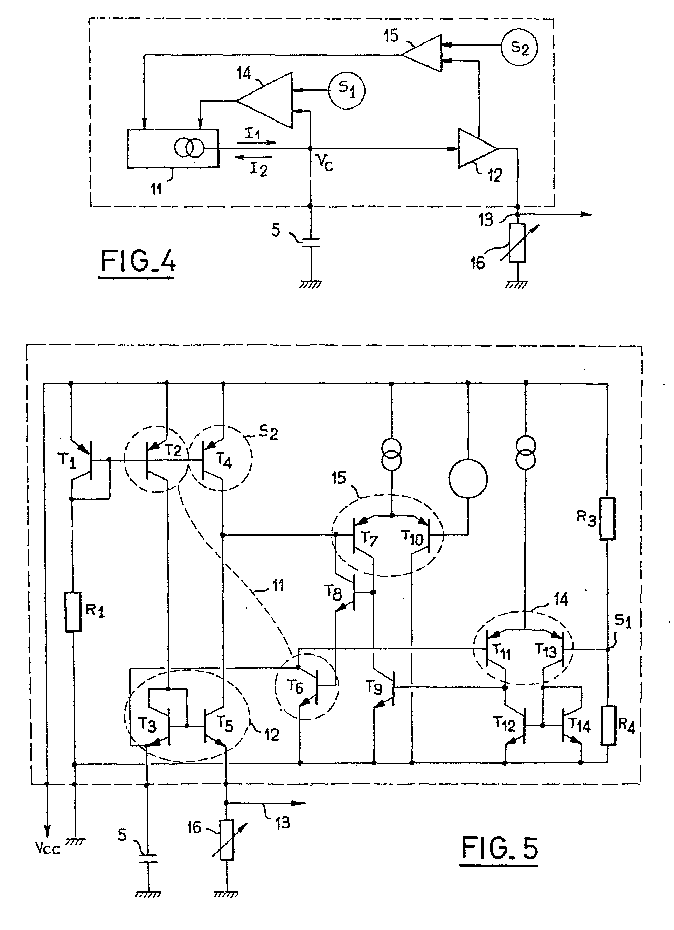

La figure 4 représente le schéma électrique, sous forme de blocs fonctionnels, de l'oscillateur selon l'invention.

Dans ce schéma, une source de courant commandable 11 est connectée à un condensateur 5; ces composants ont la même fonction que dans l'art connu. Un amplificateur 12 délivre, sous une faible impédance de sortie, une tension Vc semblable à celle présente sur le condensateur; de plus, cet amplificateur délivre, sur une sortie auxiliaire, et sous une impédance élevée, un courant semblable à celui délivré par la sortie principale 13.

La commande de la source 11 s'effectue d'une façon différente des systèmes connus: en effet, si l'un des changements d'état est commandé par un comparateur de tensions 14, l'autre est commandé par un comparateur de courants 15.

C'est ainsi que, lorsque le courant de sortie dépasse un seuil de courant $S_2$, le comparateur de courant 15 applique au générateur 11 un signal de commande qui le force à absorber un courant $I_2$. La tension aux bornes de la capacité décroît alors à la vitesse:

$$\frac{dVc}{dt} = -\frac{I_2}{C}$$

jusqu'au seuil de tension $S_1$; à ce moment, le comparateur de tension 14 force le générateur 11 à fournir le courant $I_1$; la tension aux bornes de la capacité croît alors à la vitesse:

$$\frac{dVc}{dt} = \frac{I_1}{C}$$

et le cycle recommence.

Le seuil $S_2$ est atteint à un moment qui dépend de l'impédance de sortie, constituée de préférence par une résistance 16 connectée entre la sortie 13 et le potentiel de référence: le courant de seuil $S_2$ est atteint pour une tension sur le condensateur, proportionnelle à cette résistance de sortie. Dans ce nouveau type d'oscillateur, il est donc possible de régler la période en agissant sur la résistance variable de sortie, montée en pont diviseur du seuil $S_2$. Ceci permet de réaliser un oscillateur sous forme de circuit intégré monolithique, utilisant seulement deux connexions externes (outre celles amenant les tensions d'alimentation),
- l'une pour connecter le condensateur,
- l'autre sert à la fois de sortie à faible impédance interne et de connexion de réglage de la période.

La figure 5 permettra de mieux comprendre le fonctionnement de l'oscillateur selon l'invention, dont elle donne le schéma électrique plus détaillé.

Les blocs fonctionnels de la figure 4 sont identifiés sur la figure 5 par une ligne en pointillés.

Selon ce schéma, le transistor $T_2$ agit comme source de courant $I_1$ pour charger le condensateur 5 extérieur à travers le transistor $T_3$ qui, avec son collecteur et sa base reliés, a la fonction d'une diode; le transistor $T_4$ constitue la source de courant de référence pour le seuil $S_2$. Il est avantageux que ces deux courants restent dans le même rapport quand la tension d'alimentation du circuit varie; c'est pourquoi les transistors $T_2$ et $T_4$ constituent avec le transistor $T_1$ un miroir de courant. $T_1$, $T_2$ et $T_4$ sont réalisés simultanément et ont même structure: comme leurs émetteurs et leurs bases sont respectivement reliés, leurs courants de collecteur restent proportionnels à la surface de leurs jonctions base-émetteur. Ainsi, quand la tension d'alimentation augmente, le courant collecteur du transistor $T_1$ augmente proportionnellement. Si son gain en courant est suffisant, les courant collecteurs des transistors $T_2$ et $T_4$ augmentent eux aussi, proportionnellement, et la tension sur le condensateur croît plus vite, mais comme le seuil $S_2$ est en même temps devenu plus élevé, la période de l'oscillateur reste sensiblement constante.

Le transistor $T_5$ constitue un amplificateur à collecteur commun: la tension appliquée sur sa base se retrouve sur son émetteur, diminuée d'un seuil de tension base-émetteur, avec la faible impédance interne caractéristique de ce montage. En même temps, si le gain en courant du transistor $T_5$ est élevé, son courant collecteur est pratiquement égal à son courant d'émetteur; le transistor $T_5$ réalise donc la fonction de l'amplificateur 12 de la figure 4. Il est commode d'utiliser un transistor $T_3$, connecté comme une diode, entre la base du transistor $T_5$ et le condensateur 5: ainsi la tension base-émetteur de $T_3$, pratiquement égale à celle de $T_5$, fait que la tension d'émetteur de $T_5$ est presque égale à la tension du condensateur; cependant $T_3$ peut être remplacé par un court-circuit sans nuire au fonctionnement de l'oscillateur.

Le transistor $T_7$ a son émetteur polarisé à une tension inférieure au potentiel d'alimentation, et reçoit sur sa base la différence des courants collecteurs de $T_4$ et $T_5$. Dès que le courant du transistor $T_5$, égal au courant de sortie, devient supérieur à celui du transistor $T_4$, $T_7$ délivre un courant collecteur important: $T_7$ joue donc le rôle du comparateur de courant 15 de la figure 4. Dans le présent exemple, la polarisation d'émetteur, nécessaire pour que le transistor $T_7$ puisse se bloquer, est apportée par le transistor $T_{10}$, convenablement alimenté. Les transistors $T_7$ et $T_8$ constituent ensemble un thyristor: dès que $T_7$ fournit un courant collecteur, il alimente la base de $T_8$ qui alimente à son tour la base de $T_7$: ainsi $T_7$ et $T_8$ restent bloqués tant que le courant collecteur de $T_5$ est inférieur à celui de $T_4$; dès qu'il est devenu supérieur, $T_7$ et $T_8$ deviennent et restent saturés. En même temps, le transistor $T_8$ alimente par son émetteur la base de $T_6$ qui décharge très rapidement le condensateur.

Les transistors $T_{11}$, $T_{12}$, $T_{13}$, $T_{14}$ constituent un comparateur de tension selon un schéma classique. La base de $T_{13}$ est polarisée à la tension du seuil $S_1$ prélevée sur le pont diviseur $R_3$ et $R_4$; la base de $T_{11}$ est portée à la même tension que la capacité en étant reliée à cette capacité. Quand le potentiel de base de $T_{11}$ devient inférieur au seuil $S_1$, $T_{11}$ devient conducteur et $T_{12}$ se bloque; $T_9$ reçoit alors un courant de base important et absorbe tout le courant collecteur de $T_7$. Le transistor $T_8$ ne reçoit plus de courant base et se bloque, ce qui bloque aussi $T_7$. Le transistor $T_6$ ne reçoit plus de courant provenant de $T_8$; il se bloque et le condensateur reçoit à nouveau le courant $I_1$ provenant de $T_2$.

Le circuit réalisé selon la figure 5 correspond à la description en schéma-blocs de la figure 4:
- $T_2$ et $T_6$ constituent la source de courant commandable 11, qui peut soit charger le condensateur 5 avec un courant $I_1$, soit le décharger avec un courant $I_2$ plus élevé.
- $T_5$ constitue l'amplificateur abaisseur d'impédance 12 et son collecteur absorbe un courant égal au courant de sortie qui dépend de la résistance 16.
- Ce courant est comparé au courant du seuil de référence $S_2$ fourni par le collecteur du tran-

sistor $T_4$: quand il lui devient supérieur, $T_7$ joue le rôle du comparateur 15 et commande la décharge du condensateur. Le thyristor $T_7$, $T_8$ constitue la mémoire de cette source de courant: il assure que la décharge continue jusqu'à ce que la tension de sortie atteigne le seuil $S_1$. Les transistors $T_{11}$, $T_{12}$, $T_{13}$, $T_{14}$ constituent le comparateur de tension 14: ils commandent le retour de la source $T_2$ - $T_6$ au courant $I_1$, en bloquant le thyristor $T_7$ - $T_8$; celui-ci a une fonction de mémoire en restant bloqué jusqu'à ce que le seuil $S_2$ soit atteint à nouveau.

L'oscillateur délivre une tension en dents de scie constituée par des rampes montantes de pente fixe

$$\frac{dV_c}{dt} = \frac{I_1}{C}$$

suivies de rampes descendantes de durée considérablement plus faible; la durée des rampes montantes, pratiquement égale à la période, peut être réglée en faisant varier la résistance connectée entre la borne de sortie 13 et le potentiel de référence.

L'oscillateur en dents de scie décrit est conçu en particulier en vue de la réalisation sous forme de circuit intégré sur un cristal semiconducteur monolithique.

Il est destiné à tout appareil d'instrumentation nécessitant un générateur de dents de scie, mais plus particulièrement au balayage vertical de lignes des récepteurs de télévision.

## Revendications

1. Circuit oscillateur, générateur de dents de scie, comportant un condensateur (5), alimenté par un générateur de courant (11) lequel fonctionne dans deux sens et, soit fournit au condensateur un courant ($I_1$), soit absorbe un courant ($I_2$), et un amplificateur suiveur (12), lequel délivre sur la borne de sortie (13) le courant en dent de scie, caractérisé en ce qu'un premier comparateur (14) compare la tension $V_c$ aux bornes de la capacité (5) à celle d'un premier seuil ($S_1$) de tension prédéterminée et qu'un second comparateur (15) compare le courant de sortie à un second seuil ($S_2$) de courant prédéterminé, chaque comparateur restant bloqué dans son état jusqu'à ce que l'autre comparateur ait atteint le seuil lui correspondant, les comparateurs appliquant des signaux de commande au générateur de courant pour déterminer les intervalles de temps durant lesquels il fournit un courant ($I_1$) et durant lesquels il absorbe un courant ($I_2$).

2. Circuit oscillateur selon la revendication 1, caractérisé en ce que, lorsque la tension ($V_c$) aux bornes de la capacité atteint la valeur du seuil ($S_1$) de tension prédéterminé, le comparateur de tension (14) oblige le générateur de courant (11) à fonctionner dans un premier sens.

3. Circuit oscillateur selon la revendication 1, caractérisé en ce que, lorsque le courant de sortie atteint la valeur de seuil ($S_2$) de courant prédéterminé, le comparateur de courant (15) oblige le générateur de courant (11) à fonctionner dans un second sens.

4. Circuit oscillateur selon la revendication 1, caractérisé en ce qu'une résistance variable (16) connectée entre la borne de sortie du circuit (13) et le potentiel de référence assure le réglage de fréquence des dents de scie.

5. Circuit oscillateur selon la revendication 1, caractérisé en ce qu'il est réalisé sous forme monolithique, en circuit intégré sur un cristal semiconducteur.

6. Récepteur de télévision dont le balayage vertical de lignes est caractérisé en ce qu'il comporte un circuit oscillateur selon l'une des revendications 1 à 5.

## Patentansprüche

1. Sägezahnförmigen Strom erzeugender Schwingkreis mit einem durch einen in zwei Richtungen arbeitenden Stromerzeuger (11) gespeisten Kondensator (5), wobei der Stromerzeuger entweder den Kondensator mit einem Strom ($I_1$) speist oder einen Strom ($I_2$) aufnimmt, sowie mit einem den sägezahnförmigen Strom an einen Ausgangsanschluss (13) anlegenden Folgeverstärker (12), dadurch gekennzeichnet, dass ein erster Vergleicher (14) die zwischen den Anschlussklemmen des Kondensators (5) auftretende Spannung $V_c$ mit einem vorbestimmten ersten Grenzwert einer Spannung ($S_1$) vergleicht, und dass ein zweiter Vergleicher (15) die Augangsstromstärke mit einem vorbestimmten Grenzwert ($S_2$) einer Stromstärke vergleicht, wobei jeder Vergleicher in seinem Zustand gesperrt bleibt, bis der andere Vergleicher den ihm entsprechenden Grenzwert erreicht hat, während die Vergleicher dem Stromerzeuger Steuersignale übermitteln, um die Zeitspannen zu bestimmen, während welcher derselbe einen Strom ($I_1$) erzeugt und während welcher er einen Strom ($I_2$) aufnimmt.

2. Schwingkreis nach Anspruch 1, dadurch gekennzeichnet, dass, wenn die Spannung ($V_c$) an den Kondensatorklemmen den vorbestimmten Spannungs-Grenzwert ($S_1$) erreicht, der Spannungsvergleicher (14) den Stromerzeuger (11) derart steuert, dass letzterer in einer ersten Richtung arbeitet.

3. Schwingkreis nach Anspruch 1, dadurch gekennzeichnet, dass, wenn die Ausgangsstromstärke den vorbestimmten Stromstärken-Grenzwert ($S_2$) erreicht, der Stromstärkenvergleicher (15) den Stromerzeuger (11) derart steuert, dass letzterer in einer zweiten Richtung arbeitet.

4. Schwingkreis nach Anspruch 1, dadurch gekennzeichnet, dass die Sägezahnfrequenz durch einen zwischen dem Ausgangsanschluss (13) des Kreises und der Referenzspannung liegenden Regelwiderstand (16) gesteuert wird.

5. Schwingkreis nach Anspruch 1, dadurch gekennzeichnet, dass er monolithisch in Form eines auf einem Halbleiterkristall angeordneten Integralstromkreises ausgebildet ist.

6. Fernsehempfänger dessen vertikales Bildlinienabtastungsystem dadurch gekennzeichnet ist, dass es einen Schwingkreis nach einem der Ansprüche 1 bis 5 aufweist.

**Claims**

1. A sawtooth-shaped current generating oscillating circuit comprising a capacitator (5) fed by a current generator (11) which operates in two directions by either feeding the capacitor with a current ($I_1$) or absorbing a current ($I_2$), and a follow-up amplifier (12) transmitting to an output terminal (13) the sawtooth-shaped current, characterized in that a first comparator (14) compares the voltage Vc et the terminals of the capacitator (5) to that of a first predetermined voltage threshold value ($S_1$), and in that a second comparator (15) compares the output current to a second predetermined current threshold value ($S_2$), each comparator remaining blocked in its state until the other comparator has reached the threshold value related to it, said comparators applying control signals to the current generator for determining the time intervals during which the latter produces a current ($I_1$) and during which it absorbs a current ($I_2$).

2. An oscillating circuit according to claim 1, characterized in that, when the voltage (Vc) at the terminals of the capacitator reaches the predetermined voltage threshold value ($S_1$), the voltage comparator (14) causes the current generator (11) to operate in a first direction.

3. An oscillating circuit according to claim 1, characterized in that, when the output current reaches the predetermined current threshold value ($S_2$), the current comparator (15) causes the current generator (11) to operate in a second direction.

4. An oscillating circuit according to claim 1, characterized in that the sawtooth frequency is controlled by a variable resistor (16) connected between the outlet terminal (13) of the circuit and the reference potential.

5. An oscillating circuit according to claim 1, characterized in that it is a monolithic structure in the form of an integrated circuit applied onto a semiconductor crystal.

6. A television receiver wherein the vertical line scanning system is characterized in that it comprises an oscillating circuit according to any one of claims 1 to 5.

FIG_1

FIG_2

FIG_3

FIG.4

FIG. 5